# EUROPEAN PATENT APPLICATION

(11) **EP 4 601 009 A1**
(43) Date of publication of application: **13.08.2025**
(21) Application number: 24156787.4
(22) Date of filing: 09.02.2024
(51) Int. Cl.: H01L 29/10, H01L 29/40, H01L 29/417, H01L 29/78, H01L 29/36, H01L 21/336

(54) **SEMICONDUCTOR DEVICE AND METHOD OF PROVIDING A PLUG IN A SEMICONDUCTOR DEVICE**

(71) Applicant: Nexperia B.V., 6534 AB Nijmegen (NL)
(72) Inventor: Yu, Zheng, Shanghai (CN); Kim, Hungjin, Shanghai (CN); Wang, Zhengkang, Shanghai (CN)
(74) Representative: Pjanovic, Ilija

(57) **Abstract**

A semiconductor device comprising a cell. The cell comprises: a first region of a first conductivity type, a second region of the first conductivity type, a third region of a second conductivity type opposite to the first conductivity type and operably coupled between the first region and the second region, a gate electrode operably coupled with the third region to selectively allow or prevent current flow between the first region and the second region via the third region, and a plug electrically connected with the third region. The plug has a higher electrical conductivity than the third region and is operable to improve electrical conductivity of the third region. The first conductivity type is one of p-type or n-type and the second conductivity type is another one of p-type or n-type.

## Description

### TECHNICAL FIELD

Embodiments described herein relate to a semiconductor device and a method for providing a plug in a semiconductor device.

### BACKGROUND

Semiconductor devices such as metal oxide semiconductor field effect transistors (MOSFET) are known.

An issue associated with MOSFET is parasitic bipolar junction transistor (BJT) turn-on (i.e., unwanted turn-on), which may occur when a current induces sufficient voltage across the internal base (body) resistance of the MOSFET. Such unwanted parasitic BJT turn-on may induce avalanche breakdown and undesirably affect device ruggedness (i.e., the capacity to sustain an avalanche current during an unclamped inductive load switching event), and may even damage the MOSFET. This issue may be more problematic for a bidirectional MOSFET with a deeply embedded body region, as it is difficult to short (electrically connect) the deeply embedded body region with the source region of the MOSFET for bidirectional operation.

Another issue associated with MOSFET (including bidirectional MOSFET) relates to optimization of drain-source on-resistance R_{DS(on)} and drain-source breakdown voltage BV_{DSS}. Ideally, a MOSFET should have a low drain-source on-resistance and a high drain-source breakdown voltage BV_{DSS}. However, in practice, these parameters (both depend on the electrical conductivity (e.g., doping level) and thickness of the drift region) would increase or decrease together and hence require a trade-off.

### SUMMARY

In a first aspect, there is provided a semiconductor device comprising a cell. The cell comprises: a first region of a first conductivity type, a second region of the first conductivity type, a third region of a second conductivity type opposite to the first conductivity type and operably coupled between the first region and the second region, a gate electrode operably coupled with the third region to selectively allow or prevent current flow between the first region and the second region via the third region, and a plug electrically connected with the third region. The plug has a higher electrical conductivity than the third region and is operable to improve electrical conductivity of the third region. The first conductivity type is one of p-type or n-type whereas the second conductivity type is another one of p-type or n-type. The first and second regions are operable as drift regions. The third region is operable as a body region.

During operation of the semiconductor device, the plug improves electrical conductivity of the third region. The improved electrical conductivity of the third region can reduce base resistance of a parasitic BJT defined by the first and second drift regions and the third body region, hence prevent parasitic BJT turn-on (unwanted turn-on). In some embodiments, this can improve device ruggedness and help to improve unclamped inductive switching (UIS) performance of the semiconductor device.

In some embodiments, the plug is disposed such that it can facilitate pick up of (electrical connection with) the third region. This may be particularly useful for a cell with a deeply embedded third region, which is otherwise difficult to electrically connect with.

In some embodiments, the plug can facilitate provision of a RESURF (reduced surface electric field) arrangement for reducing surface electric field locally.

The first region may be electrically connected with a first electrode and the second region may be electrically connected with a second electrode. The first electrode is one of a drain electrode or a source electrode whereas the second electrode is another one of a drain electrode or a source electrode. In some embodiments in which the semiconductor device is a bidirectional semiconductor device, the first electrode is selectively operable as one of a drain electrode or a source electrode and the second electrode is selectively operable as another one of a drain electrode or a source electrode.

Optionally, the semiconductor device is a trench gate semiconductor device. The trench gate semiconductor device may be particularly suitable for low voltage applications.

In some embodiments, the cell further comprises a first trench extending in a first direction into the first region, the second region, and the third region, and a dielectric arrangement arranged in the first trench. The first trench may terminate in any part of the second region. The gate electrode is arranged in the first trench, the dielectric arrangement surrounds the gate electrode in the first trench, and at least part of the third region is disposed between the first region and the second region in the first direction such that the first region and the second region are spaced apart in the first direction. In some embodiments, the dielectric arrangement is made of silicon dioxide.

Optionally, the cell further comprises a second trench extending in the first direction into the first region and the third region. The second trench is spaced apart from the first trench in a second direction perpendicular to the first direction, and the plug is arranged in the second trench. In some embodiments, the third region includes opposite ends in the first direction, and the second trench extends into the third region such that the second trench terminates, in the first direction, midway between the opposite ends of the third region. This can enable a more even pick up of (electrical connection with) the third region.

Optionally, the cell further comprises a dielectric operably coupled between the plug and the first region. In some embodiments, the dielectric is made of silicon dioxide. In some embodiments, at least part of the dielectric is disposed in the second trench and between the plug and the first region. In some embodiments, the dielectric can facilitate provision of a RESURF (reduced surface electric field) arrangement for reducing surface electric field locally.

Optionally, the second trench and/or the plug extend in the first direction along an edge of the cell. In some embodiments in which the second trench extends in the first direction along an edge of the cell, the second trench may be joined with the second trench of an adjacent cell to form a single larger second trench. In some embodiments in which the plug extends in the first direction along an edge of the cell, the plug may be in contact with or integral with the plug of an adjacent cell to form an integral plug. In these cases, the integral plug extends in the first direction in a center region between the first trenches of the two cells in the second direction (i.e., mesa center region). This can enable a more even pick up of (electrical connection with) the third regions of the cells.

Optionally, the cell further comprises a fourth region of the second conductivity type operably coupled with the third region, and part of the second region is disposed between the first trench and the fourth region in the second direction. In some embodiments, the second portion of the third region is disposed between the plug and the fourth region in the first direction. In some embodiments, the fourth region can facilitate provision of a RESURF (reduced surface electric field) arrangement for reducing surface electric field locally. In some embodiments, the fourth region is a pillar-like region.

Optionally, the fourth region extends in the first direction along an edge of the cell. In some embodiments, the fourth region is in contact with the third region. In embodiments in which the semiconductor device includes (at least) two of the cells that are arranged in parallel adjacent each other, the fourth regions of the two cells form an integral fourth region, which extends in the first direction and is disposed in a center region between the first trenches of the two cells in the second direction (i.e., mesa center region).

Optionally, the semiconductor device is a shielded gate trench (SGT) semiconductor device. The SGT semiconductor device may be particularly suitable for low voltage applications.

In some embodiments, the cell further comprises a shield electrode arranged in the first trench. The shield electrode is disposed on one side of the gate electrode in the first direction, and the dielectric arrangement further surrounds the shield electrode such the shield electrode and the gate electrode are not in contact with each other in the first trench. The shield electrode can facilitate optimization of doping concentration in the first region or the second region, hence facilitate optimization of drain-source on-resistance R_{DS(on)} of the semiconductor device and drain-source breakdown voltage BV_{DSS} of the semiconductor device.

In some embodiments, the cell further comprises first and second shield electrodes arranged in the first trench. One of the first shield electrode and the second shield electrode is disposed on one side of the gate electrode in the first direction, another one of the first shield electrode and the second shield electrode is disposed on another side of the gate electrode in the first direction, and the dielectric arrangement further surrounds the first shield electrode and the second shield electrode such the first shield electrode, the second shield electrode, and the gate electrode are not in contact with each other in the first trench.

In some embodiments, the first shield electrode is disposed adjacent to the first region (operable as drift region). In some embodiments, the second shield electrode is disposed adjacent to the second region (operable as drift region) and is aligned with the fourth region in the second direction. The first shield electrode can facilitate optimization of doping concentration of the first region, hence facilitate optimization of drain-source on-resistance R_{DS(on)} of the semiconductor device and drain-source breakdown voltage BV_{DSS} of the semiconductor device. The second shield electrode can facilitate optimization of doping concentration of the second region, hence facilitate optimization of drain-source on-resistance R_{DS(on)} of the semiconductor device and drain-source breakdown voltage BV_{DSS} of the semiconductor device.

In some embodiments, the semiconductor device is a bidirectional semiconductor device, and the gate electrode is operable to selectively allow or prevent current flow from the first region to the second region via the third region and to selectively allow or prevent current flow from the second region to the first region via the third region. In some embodiments, the bidirectional semiconductor device has a deeply embedded third region so the plug may be particularly useful for facilitating pick up of the third region.

In some embodiments, the plug is a metallic plug. For example, the metallic plug can be made of aluminum. In some embodiments, aluminum is preferred as it can be made more cost effectively using some techniques. For example, the metallic plug can be made of tungsten. In some embodiments, tungsten is preferred as it can be more readily filled in narrower space (e.g., narrower gap) using some techniques.

In some embodiments, the plug is of the second conductivity type. In some embodiments, depending on the techniques used, a plug of the second conductivity type can be fabricated more easily and/or cheaper than a metallic plug.

Optionally, the plug is in the form of a pillar.

Optionally, the third region comprises a first portion and a second portion having a higher level of conductivity than the first portion, and the plug is in contact with the second portion. The second portion can facilitate electrical connection between the plug and the third region.

Preferably, the semiconductor device includes multiple ones of the cell. The cells may be arranged in parallel, one adjacent another, to form a cell array. In some embodiments, the cells are arranged in a single die or a single chip. In some embodiments in which the semiconductor device is a bidirectional semiconductor device, the arrangement of the cells in a single die or a single chip can reduce assembly time and cost as well as package and/or substrate resistance (e.g., compared with bidirectional semiconductor device formed by back-to-back or front-to-front arranged unidirectional semiconductor devices).

In a second aspect, there is provided a method of providing a plug in a cell of a semiconductor device. The semiconductor device in the second aspect may or may not be the semiconductor device of the first aspect. The method comprises: (a) obtaining a semiconductor device with a cell, which comprises: a first region of a first conductivity type, a second region of the first conductivity type, a third region of a second conductivity type opposite to the first conductivity type and operably coupled between the first region and the second region, a gate electrode operably coupled with the third region to selectively allow or prevent current flow between the first region and the second region via the third region, a first trench extending in a first direction into the first region, the second region, and the third region, a dielectric arrangement arranged in the first trench, and a second trench extending in the first direction into the first region and the third region and spaced apart from the first trench in a second direction perpendicular to the first direction. The gate electrode is arranged in the first trench and the dielectric arrangement surrounds the gate electrode in the first trench. At least part of the third region is disposed between the first region and the second region in the first direction such that the first region and the second region are spaced apart in the first direction. The method further comprises: (b) forming a dielectric on a sidewall of the second trench. The sidewall is provided by the first region and part of the third region. The method further comprises: (c) forming a plug, which has a higher electrical conductivity than the third region, in the second trench with the dielectric such that (i) the plug is electrically connected with the third region, and (ii) at least part of the dielectric is disposed in the second trench and between the plug and the first region.

In some embodiments, for the cell of the semiconductor device obtained in (a), the second trench extends in the first direction along an edge of the cell.

In some embodiments, in (c), the plug formed extend in the first direction along an edge of the cell.

In some embodiments, for the cell of the semiconductor device obtained in (a), the third region includes opposite ends in the first direction, and the second trench extends into the third region such that the second trench terminates, in the first direction, at or about midway between the opposite ends of the third region.

In some embodiments, for the cell of the semiconductor device obtained in (a), the cell further comprises a fourth region of the second conductivity type operably coupled with the third region, and part of the second region is disposed between the first trench and the fourth region in the second direction.

In some embodiments, in (c), the plug is formed such that the second portion of the third region is disposed between the plug and the fourth region in the first direction. In some embodiments, the fourth region extends in the first direction along an edge of the cell. In some embodiments, the fourth region is in contact with the third region.

In some embodiments, for the cell of the semiconductor device obtained in (a), the cell further comprises a shield electrode arranged in the first trench. The shield electrode is disposed on one side of the gate electrode in the first direction, and the dielectric arrangement further surrounds the shield electrode such the shield electrode and the gate electrode are not in contact with each other in the first trench.

In some embodiments, for the cell of the semiconductor device obtained in (a), the cell further comprises first and second shield electrodes arranged in the first trench. One of the first shield electrode and the second shield electrode is disposed on one side of the gate electrode in the first direction, another one of the first shield electrode and the second shield electrode is disposed on another side of the gate electrode in the first direction, and the dielectric arrangement further surrounds the first shield electrode and the second shield electrode such the first shield electrode, the second shield electrode, and the gate electrode are not in contact with each other in the first trench.

In some embodiments, the gate electrode is operable to selectively allow or prevent current flow from the first region to the second region via the third region and to selectively allow or prevent current flow from the second region to the first region via the third region.

Optionally, in (c), the plug is in the form of a pillar and extends in the first direction.

In some embodiments, forming the dielectric in (b) comprises depositing the dielectric in the second trench on the sidewall. In some embodiments, the dielectric is made of silicon dioxide. In some embodiments, with the dielectric and the plug formed in (b) and (c), at least part of the dielectric is disposed in the second trench and between the plug and the first region.

In some embodiments, the plug is a metallic plug, and forming the plug in (c) comprises depositing metal in the second trench on the dielectric. The metal may be aluminum, tungsten, etc. In some embodiments, after (b), the second trench with the formed dielectric defines a space and in (c), the forming includes filling the space with the metal.

In some embodiments, the plug is of the second conductivity type, and forming the plug in (c) comprises depositing material of the second conductivity type in the second trench. In some embodiments, after (b), the second trench with the formed dielectric defines a space and in (c), the forming includes filling the space with the material of the second conductivity type.

In some embodiments, the method further comprises: prior to forming the plug in (c), processing a portion of the third region that provides the base of the second trench to increase a level of electrical conductivity so as to provide a higher conductivity portion in the third region; and the forming of the plug in (c) comprises depositing metal or material of the second conductivity type to contact the higher conductivity portion. In some embodiments, the processing includes implanting impurities of the second conductivity type in the portion of the third region.

In a third aspect, there is provided a semiconductor device having a cell formed based on the method of the second aspect.

In a fourth aspect, there is provided an electronic device or system comprising the semiconductor device of the first aspect.

In a fifth aspect, there is provided an electronic device or system comprising the semiconductor device of the semiconductor device of the third aspect.

Other features and aspects will become apparent by consideration of the detailed description and accompanying drawings. Any feature(s) described in relation to one aspect or example may be combined with any other feature(s) described in relation to any other aspect or example as appropriate and applicable.

Terms of degree such as "generally", "about", "substantially", or the like, are used, depending on context, to account for one or more of the following: manufacture tolerance, degradation, trend, tendency, or imperfect practical condition(s).

Unless otherwise specified, terms such as "connected", "coupled", or "mounted", are intended to cover both direct and indirect "connection", "coupling", or "mounting".

### BRIEF DESCRIPTION OF THE DRAWINGS

Embodiments of the invention will now be described, by way of example, with reference to the accompanying drawings (which may not be drawn to scale) in which:
Fig. 1 is a schematic diagram of a cell of a semiconductor device of in one embodiment of the invention;
Fig. 2 is a flowchart illustrating a method for providing a plug in a cell of a semiconductor device in one embodiment of the invention;
Fig. 3A is a schematic diagram of a cell of a bidirectional shielded gate trench (SGT) MOSFET in one embodiment of the invention;
Fig. 3B is a schematic diagram of a bidirectional shielded gate trench (SGT) MOSFET with a cell array formed by the cells of Fig. 3A in one embodiment of the invention;
Figs. 4A to 4T are schematic diagrams illustrating a method of making the cell of the bidirectional SGT MOSFET of Fig. 3A in one embodiment of the invention;
Fig. 5 is a schematic diagram of a half-cell of a SGT MOSFET in one embodiment of the invention;
Fig. 6 is a schematic diagram of a half-cell of a SGT MOSFET in one embodiment of the invention;
Fig. 7 is a schematic diagram of a half-cell of a SGT MOSFET in one embodiment of the invention; and
Fig. 8 is a schematic diagram of a half-cell of a SGT MOSFET in one embodiment of the invention.

### DETAILED DESCRIPTION

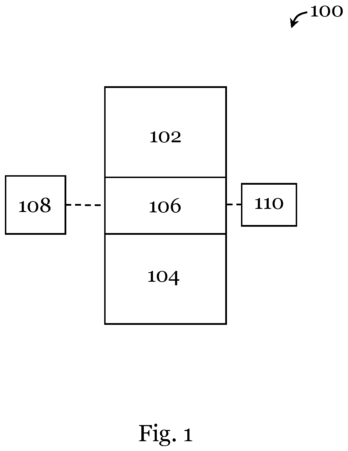

Fig. 1 schematically shows a cell 100 of a semiconductor device in one embodiment of the invention. The cell 100 includes a first region 102, a second region 104, and a third region 106 operably coupled between the first and second regions 102, 104. The first and second regions 102, 104 are of a first conductivity type and the third region 106 is of a second conductivity type. The first conductivity type is p-type and the second conductivity type is n-type, or, the first conductivity type is n-type and the second conductivity type is p-type. The first and second regions 102, 104 are operable as drift regions whereas the third region 106 is operable as body region.

The cell 100 also includes a gate electrode 108 operably coupled with the third region 106 to selectively allow or prevent current flow between the first and second regions 102, 104 via the third region 106 (e.g., from the first region 102 to the second region 104 via the third region 106, or from the second region 104 to the first region 102 via the third region 106, or both).

The cell 100 also includes a plug 110 electrically connected with the third region 106. The plug 110 has a higher electrical conductivity than the third region 106 hence can improve electrical conductivity of the third region 106. The plug 110 can be metallic (e.g., made of aluminum, tungsten, etc.) or can be of the same conductivity type as the third region 106. The plug 110 can provide additional contact for facilitating electrical connection with the third region 106. In one example, the plug 110 extends along an edge of the cell 100 such that the plug 110 may be in contact with or integral with another plug (same as plug 110) of an adjacent cell (which may have the same configuration as the cell 100). In one example, the third region 106 includes a portion with higher level of conductivity and a portion with lower level of conductivity, and the plug 110 is in contact with the portion with higher level of conductivity. The plug 110 has a higher electrical conductivity than the portion with higher level of conductivity.

The first and second regions 102, 104 can each be electrically connected with a respective electrode. In one example, the first region 102 is electrically connected with a source electrode and the second region 104 is electrically connected with a drain electrode. In one example, the first region 102 is electrically connected with a drain electrode and the second region 104 is electrically connected with a source electrode. In one example, the first region 102 is electrically connected with an electrode that can selectively operate as one of a source electrode or drain electrode, and the second region 104 is electrically connected with an electrode that can selectively operate as another one of a source electrode or drain electrode. In one example, the semiconductor device with the cell 100 is a trench gate semiconductor device. In one example, the semiconductor device with the cell 100 is a shielded gate trench semiconductor device. In one example, the cell 100 also includes a dielectric operably coupled between the plug 110 and the first region 102.

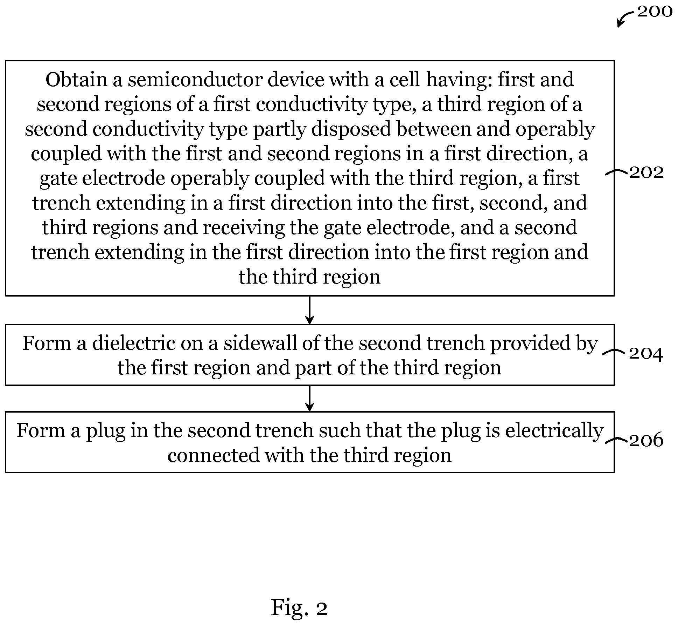

Fig. 2 illustrates a method 200 for providing a plug in a cell of a semiconductor device in one embodiment of the invention. The cell provided with the plug using method 200 may be the cell 100 of Fig. 1.

In this embodiment, the method 200 includes, in 202, obtaining a semiconductor device with a cell. The cell includes: first and second regions of a first conductivity type, and a third region of a second conductivity type and operably coupled between the first and second regions. At least part of the third region is disposed between the first region and the second region in a first direction such that the first region and the second region are spaced apart in the first direction. The cell includes: a gate electrode operably coupled with the third region to selectively allow or prevent current flow between the first and second regions via the third region, a first trench extending in a first direction, a dielectric arrangement arranged in the first trench, and a second trench extending in the first direction. The first trench extends into the first, second, and third regions, and the second trench extends into the first and third regions. The first and second trenches are spaced apart in a second direction perpendicular to the first direction. The gate electrode is arranged in the first trench and the dielectric arrangement surrounds the gate electrode in the first trench. In some examples, the second trench extends in the first direction along an edge of the cell. In some examples, the cell further includes one or more shield electrodes disposed adjacent the gate electrode in the first direction. In some examples, the cell further includes a fourth region of the second conductivity type operably coupled with (e.g., in contact with) the third region.

The method 200 further includes, in 204, forming a dielectric (e.g., silicon dioxide) on a sidewall of the second trench provided by the first region and part of the third region. In one example, the forming in 204 includes depositing the dielectric in the second trench on the sidewall.

The method 200 further includes, in 206, forming a plug in the second trench with the dielectric. The formed plug is electrically connected with the third region, and is arranged such that at least part of the dielectric is disposed in the second trench and between the plug and the first region. The plug has a higher electrical conductivity than the third region and is operable to improve electrical conductivity of the third region. In some examples, the plug extends in the first direction along an edge of the cell. In one example, the plug is a metallic plug, and the forming in 206 includes depositing the metal (e.g., aluminum, tungsten) in the second trench. In one example, the plug is of the second conductivity type, and the forming in 206 includes depositing material of the second conductivity type in the second trench.

In some examples, the method 200 may further include, prior to the forming in 206, processing a portion of the third region that provides the base of the second trench to increase its level of conductivity so as to provide a higher conductivity portion in the third region. In these examples, the forming in 206 can include depositing metal or material of the second conductivity type to contact the higher conductivity portion of the third region. The plug has a higher electrical conductivity than the higher conductivity portion of the third region.

The method 200 can be applied to provide one or more plugs in a cell array of a semiconductor device. The cell array may be formed by multiple ones of the cells 100 arranged adjacent one another in parallel.

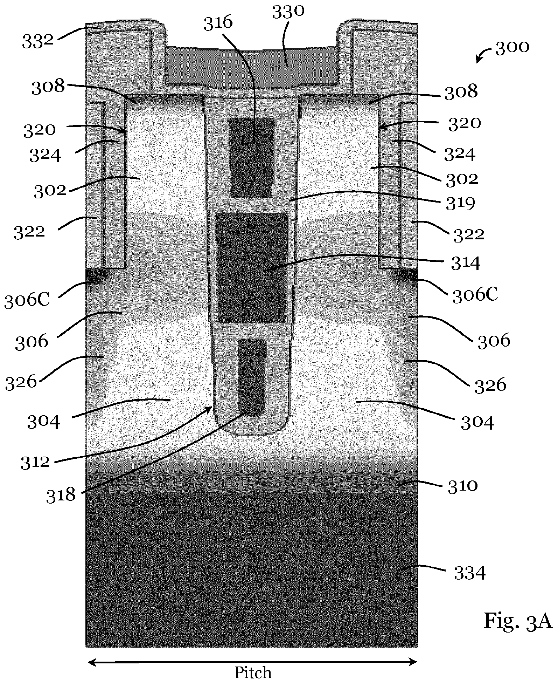

Fig. 3A shows a cell 300 of a bidirectional SGT MOSFET in one embodiment of the invention. The cell 300 in Fig. 3A can be considered as a more specific example of the cell 100 in Fig. 1. For example, the bidirectional SGT MOSFET may include a cell cluster with multiple ones of the cell 300 arranged adjacent one another in parallel (i.e., the cell 300 being a repeating unit).

As shown in Fig. 3A, in this embodiment, the cell 300 defines top and bottom sides, and two lateral sides in extending between the top and bottom sides. The cell 300 includes a layer stack that provides a first n-type region 302, a second n-type region 304, and a first p-type region 306 operably coupled and arranged between the first and second n-type regions 302, 304 in the vertical direction. The layer stack further includes a third n-type region 308 disposed above the first n-type region 302 and a fourth n-type region 310 below the second n-type region 306. The third n-type region 308 has a higher level of doping hence higher electrical conductivity than the first n-type region 302. The fourth n-type region 310 has a higher level of doping hence higher electrical conductivity than the second n-type region 306. The first n-type region 302 is disposed between the third n-type region 308 and the first p-type region 306 in the vertical direction. The second n-type region 304 is disposed between the first p-type region 306 and the fourth n-type region 310 in the vertical direction. The first p-type region 306 includes a portion 306C that has a higher level of doping hence higher electrical conductivity than the rest of the first p-type region 306. The portion 306C is disposed near the lateral side (or edge) of the cell 300. In this embodiment, the first n-type region 302 is lightly doped, the second n-type region 304 is lightly doped, the third n-type region 308 is heavily doped, and the fourth n-type region 310 is heavily doped. In this embodiment, the portion 306C is a P++ implant. In this embodiment, the first n-type region 302 is operable as a drift region, the second n-type region 304 is operable as a drift region, and the first p-type region 306 is operable as a body region. The first n-type region 302, the second n-type region 304, and the first p-type region 306 define a parasitic BJT.

The cell 300 further includes a primary trench 312 extending in a vertical direction in the layer stack from the top of the layer stack. As shown in Fig. 3A, the primary trench 312 is disposed in the middle between the two lateral sides of the cell 300, and extends vertically into the first n-type region 302, the first p-type region 306, and the second n-type region 304. The primary trench 312 tapers in the vertical direction. The primary trench 312 terminates in the second n-type region 304. In this embodiment, the sidewalls of the primary trench 312 are provided by the first n-type region 302, the first p-type region 306, and the second n-type region 304 whereas the base wall of the primary trench is provided by the second n-type region 304.

A gate electrode 314 is disposed in the primary trench 312, near a center of the primary trench 312 in the vertical direction. The gate electrode 314 is aligned with and operably coupled with the first p-type region 306. In this embodiment, the gate electrode 314 is operable to selectively allow or prevent current flow from the first n-type region 302 to the second n-type region 304 via the first p-type region 306 as well as selectively allow or prevent current flow from the second n-type region 304 to the first n-type region 302 via the first p-type region 306. In other words, the gate electrode 314 can control bidirectional current flow. Two shield electrodes 316, 318 are also disposed in the primary trench 312. One shield electrode 316 is disposed above the gate electrode 314 in the vertical direction. Another shield electrode 318 is disposed below the gate electrode 314 in the vertical direction. Each of the shield electrodes 316, 318 has a slight taper in the vertical direction and has a smaller width than the gate electrode 314. A dielectric arrangement 319 (e.g., silicon dioxide) fills the remaining space of the primary trench 312. In particular, the dielectric arrangement 319 surrounds each of the gate electrode 314 and the shield electrodes 316, 318 so that the electrodes 314, 316, 318 are not in contact with each other in the primary trench 312 and are not in contact with the layer stack. The electrodes 314, 316, 318 are made of polysilicon.

The cell 300 further includes two secondary trenches 320 extending in a vertical direction in the layer stack from the top of the layer stack and spaced apart from the primary trench 312 in the lateral direction. In this embodiment, the two secondary trenches 320 are generally identical so for simplicity only one is described below. The secondary trench 320 extends along a lateral side (or edge) of the cell 300. As shown in Fig. 3A, the secondary trench 320 extends vertically into the first n-type region 302 and the first p-type region 306. The secondary trench 320 terminates in the first p-type region 306, at about half of the depth of the first p-type region 306. In this embodiment, the sidewall of the secondary trench 320 is provided by the first n-type region 302 and the first p-type region 306 whereas the base wall of the secondary trench 320 is provided by the first p-type region 306 (including portion 306C). A plug (pillar-like) 322 extending in the vertical direction along a respective lateral side (or edge) of the cell 300 is disposed in the secondary trench 320. The plug 322 is in contact with portion 306C of the first p-type region 306, hence are electrically connected with the first p-type region 306. The plug 322 has a higher electrical conductivity than the first p-type region 306. The plug 322 may be made of metal (e.g., aluminum or tungsten), or can be of p-type material with a higher electrical conductivity than the first p-type region 306 (and a higher electrical conductivity than the portion 306C). As shown in Fig. 3A, the remaining space of the secondary trench 320 is filled with a dielectric arrangement 324 (e.g., silicon dioxide) such that dielectric is disposed between the plug 322 and the first n-type region 302. Stated another way, the plug 322 fills the space of the secondary trench (which includes the dielectric).

In this embodiment, the cell 300 further includes a second p-type region 326 extending in a vertical direction in the layer stack and along a lateral side (or edge) of the cell 300. The second p-type region 326 is a pillar region disposed below and in contact with the first p-type region 306. As shown in Fig. 3A, the second p-type region 326 is disposed such that (i) part of the second n-type region 304 is disposed between the primary trench 312 and the second p-type region 326 in the lateral direction, and (ii) the portion 306C is disposed between the plug 322 and the second p-type region 326 in the vertical direction. The second p-type region 326 may have the same or a similar level of doping hence electrical conductivity as the first p-type region 306.

The cell 300 further includes a first pickup arrangement at the top side of the cell 300 above the layer stack (or above the third n-type region 308) and a second pickup arrangement at the bottom side of the cell 300 below the layer stack (or below the fourth n-type region 310). The first pickup arrangement is arranged to electrically connect with (e.g., contact) an electrode. In this embodiment, the first pickup arrangement includes a pickup region 330 and a thin barrier metal layer 332 operably coupled between the pickup region 330 and the third n-type region 308. The pickup region 330 and the third n-type region 308 are electrically connected so that current may flow between them via the thin barrier metal layer 332. The second pickup arrangement is arranged to electrically connect with (e.g., contact) another electrode. In this embodiment, the second pickup arrangement includes a pickup region 334 electrically connected with the fourth n-type region 310. In this embodiment, in one operation mode of the semiconductor device (i.e., top drain mode), the first pickup arrangement is electrically connected with a drain electrode and the second pickup arrangement is electrically connected with a source electrode, and, in another operation mode of the semiconductor device (i.e., bottom drain mode), the first pickup arrangement is electrically connected with a source electrode and the second pickup arrangement is electrically connected with a drain electrode.

In this embodiment, the pitch of the cell 300 is about 1.5 microns.

The cell 300 in this embodiment includes various features. For example, the plug 322 can improve electrical conductivity of the first p-type region 306 during operation. This may help to reduce the base resistance and/or the common base current gain of the parasitic BJT (defined by the first and second n-type regions 302, 304 and the first p-type region 306). This may cause the parasitic BJT to be turned on at a higher current, thus improving safe operating area SOA. In other words, this may help to prevent parasitic BJT turn-on (unwanted turn-on), and improve unclamped inductive switching (UIS) performance of the semiconductor device. Also, the plug 322 can provide a connection point for electrically connecting with the first p-type region 306 hence facilitate pick up of the first p-type region 306. In this case, as the plug 322 extends into the first p-type region 306 vertically and terminates near the center of the first p-type region 306, a more even pickup can be achieved. The arrangement of the plug 322 and the dielectric in the secondary trench 320 adjacent the first n-type region 302 can facilitate provision of a RESURF (reduced surface electric field) arrangement for reducing surface electric field locally when the cell operates in the top drain mode. The arrangement of the second p-type region 326 adjacent the second n-type region 304 can facilitate provision of a RESURF (reduced surface electric field) arrangement for reducing surface electric field locally when the cell operates in the bottom drain mode. In some cases, the second p-type region 326 can be referred to as RESURF pillar. The arrangement of the shield electrodes 316, 318 can facilitate optimization of doping concentration in the drift regions, hence optimization of drain-source on-resistance R_{DS(on)} of the cell and drain-source breakdown voltage BV_{DSS} of the cell.

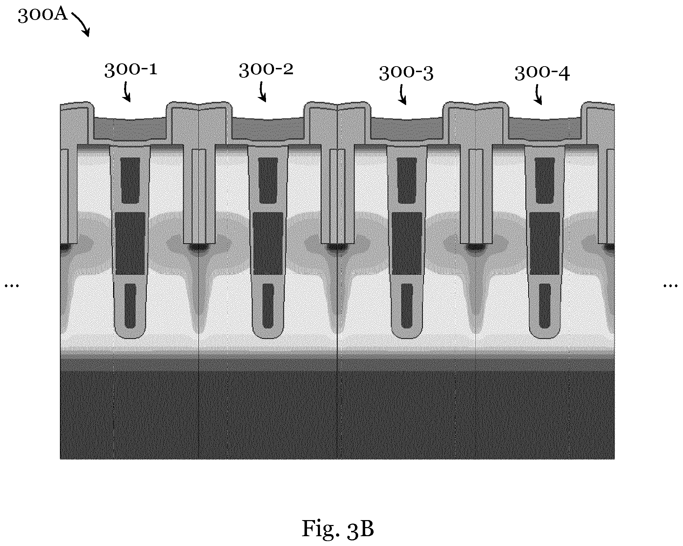

Fig. 3B shows a bidirectional shielded gate trench (SGT) MOSFET in one embodiment of the invention. The bidirectional shielded gate trench (SGT) MOSFET includes a cell array 300A with four cells 300-1, 300-2, 300-3, 300-4, arranged adjacent one another in parallel. Each respective one of the cells 300-1, 300-2, 300-3, 300-4 is the same as the cell 300 of Fig. 3A.

The bidirectional SGT MOSFET with the cell 300 or the cell array 300A can be arranged in a single die or a single chip, hence may have a relatively low package and/or substrate resistance (e.g., when compared with a bidirectional semiconductor device formed by back-to-back or front-to-front arranged unidirectional semiconductor devices).

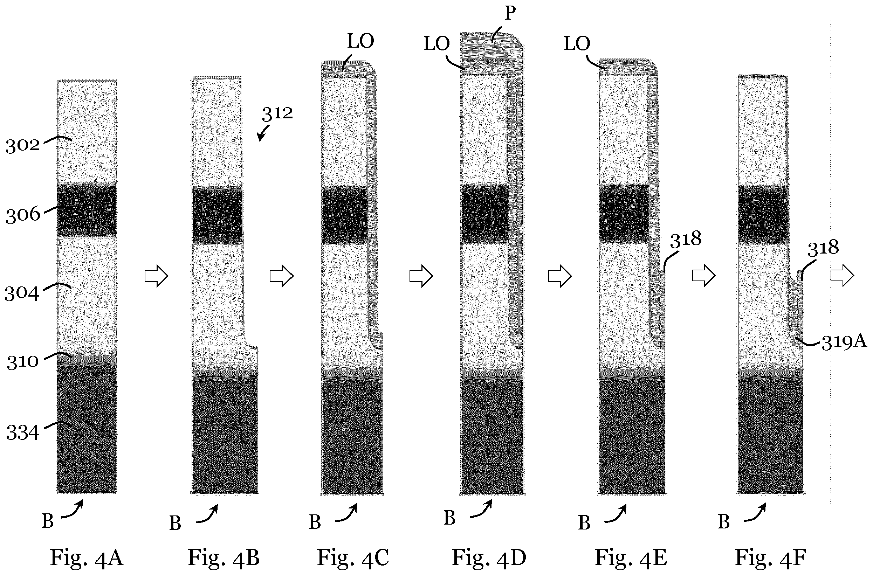

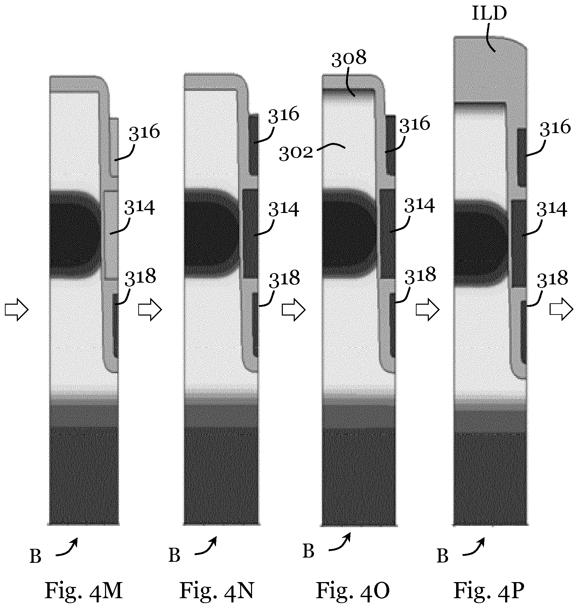

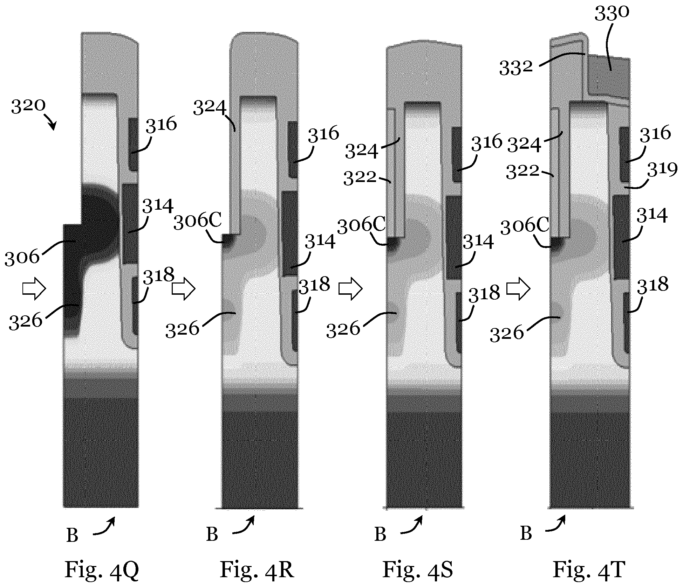

Figs. 4A to 4T illustrate a method of making the cell 300 of the bidirectional SGT MOSFET of Fig. 3A in one embodiment. In Figs. 4A to 4T, for ease of presentation, only half-cells (left half) are shown. In this embodiment, Figs. 4A to 4Q can be considered as a specific example of operation 202 in the method 200, Fig. 4R can be considered as a specific example of the operation 204 in the method 200, and Fig. 4S can be considered as a specific example of the operation 206 in the method 200.

The method includes obtaining, based on epitaxial formation, a semiconductor body B (e.g., layer stack on or with a substrate) of Fig. 4A. In this example, the semiconductor body B includes, from top to bottom in the vertical direction, the first n-type region 302, the first p-type region 306, the second n-type region 304, the fourth p-type region 310 with a higher level of doping than the second n-type region 304, and the pickup region 334. In this embodiment, the semiconductor body B can be formed in such a way that the first p-type region 306 is formed after the second n-type region 304 is formed, and the first n-type region 302 is formed after the first p-type region 306 is formed.

Then, the primary trench 312 is etched into the semiconductor body B, as shown in Fig. 4B. Liner oxide LO is formed on the walls of the primary trench 312 as well as on top surface of the semiconductor body B, as shown in Fig. 4C. Polysilicon P is deposited in the primary trench 312 (to fill the space in the primary trench 312) and on the liner oxide LO, as shown in Fig. 4D, for facilitating formation of the lower shield electrode 318. The polysilicon P is then etched back, as shown in Fig. 4E, to form the lower shield electrode 318. The liner oxide LO is pulled back to form the shield oxide 319A (part of the dielectric arrangement 319), as shown in Fig. 4F.

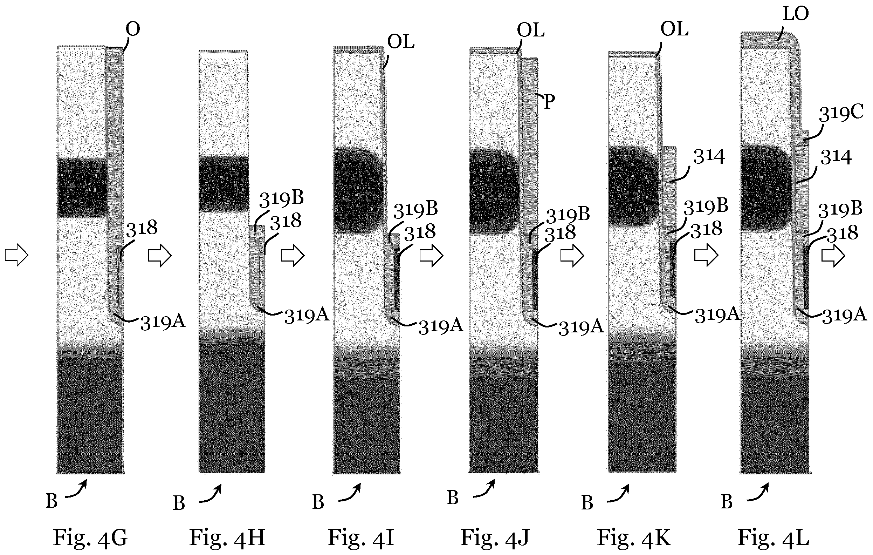

Then, oxide O is deposited in the primary trench 312, as shown in Fig. 4G, e.g., using high-density plasma deposition technique. The deposited oxide O is subjected to chemical-mechanical polishing and is then etched back, as shown in Fig. 4H, to provide the inter-electrode dielectric 319B (part of the dielectric arrangement 319).

An oxide layer OL (silicon dioxide) is then thermally grown (e.g., by converting silicon into silicon dioxide) or otherwise formed on the top surface of the semiconductor body B and on the exposed part of the sidewall of the primary trench 312, as shown in Fig. 4I.

Polysilicon P is deposited in the primary trench 312 on the oxide layer OL, and the deposited polysilicon P is then subjected to chemical-mechanical polishing, as shown in Fig. 4J. The deposited polysilicon P is then etched back to form the gate electrode 314, as shown in Fig. 4K. The part of the oxide layer OL on the lateral side of the deposited polysilicon P provides the gate oxide.

A liner oxide LO is formed on the exposed part of the primary trench 312, on the gate electrode 314, and on the top surface of the semiconductor body B, as shown in Fig. 4L. The part of the liner oxide LO above the gate electrode 314 provides the inter-electrode dielectric 319C (part of the dielectric arrangement 319).

Polysilicon is deposited in the primary trench 312 in a space defined by the deposited liner oxide LO. The polysilicon is then subjected to chemical-mechanical polishing and etched back to form the upper shield electrode 316, as shown in Fig. 4M.

An annealing process is then performed to anneal the shield and gate electrodes 314, 316, 318, as shown in Fig. 4N. An implantation process is performed to form the third n-type region 308 above the first n-type region 302, as shown in Fig. 4O. An oxide is then deposited in the primary trench 312 and on the top surface of the semiconductor body B, to form an inter-layer dielectric ILD.

Then, the secondary trench 320 is etched into the semiconductor body B, along an edge of the cell 300, and an implantation process is performed to form the second p-type region 326 below the first p-type region 306, as shown in Fig. 4Q. The formed second p-type region 326 adjacent the second n-type region 304 to provide charge balance with the second n-type region 304, i.e., increase doping concentration of second n-type region 304, hence reduce drain-source on-resistance R_{DS(on)} of the semiconductor device.

Next, oxide is deposited in the secondary trench 320. The deposited oxide is then etched back such that an oxide layer is formed on the sidewall of the secondary trench. The oxide layer provides the dielectric arrangement 324. An implantation process is performed to increase the p conductivity of the first p-type region 306, to form the portion 306C, as shown in Fig. 4R. The portion 306C is subjected to rapid thermal annealing.

A metal or a highly doped p-type conductivity material is deposited or otherwise arranged in the remaining space of the secondary trench 320, and then etched back, to form the plug 322, as shown in Fig. 4S. An oxide is then deposited over the semiconductor body B, to form an inter-layer dielectric ILD. The ILD is then subjected to partial planarization.

Finally, the pickup arrangement with the pickup region 330 (operable as a top side contact) and a thin barrier metal layer 332 is formed.

Unless other specified, the oxide referred to in the method of this embodiment is silicon dioxide.

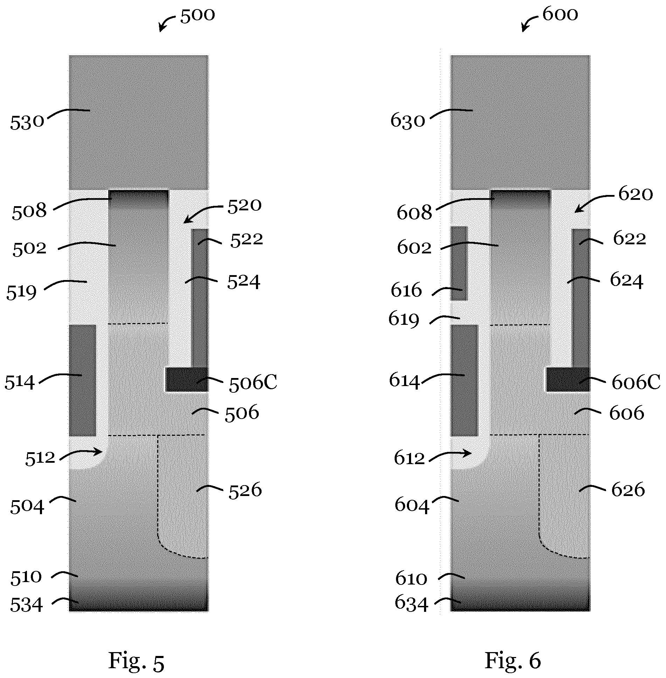

Fig. 5 shows a half-cell (right half) of a bidirectional SGT MOSFET in one embodiment of the invention. The half-cell 500 in Fig. 5 is generally the same as the half-cell (right half) of the cell 300 in Fig. 3A except without the two shield electrodes and with a shallower primary trench. In Fig. 5, components or parts that are the same as those in Fig. 3A are labeled using the same reference number used in Fig. 3A plus "200". Briefly, the half-cell 500 includes a layer stack that provides a first n-type region 502, a second n-type region 504, a first p-type region 506, a third n-type region 508, and a fourth n-type region 510. The first p-type region 506 includes a portion 506C that has a higher level of doping hence higher electrical conductivity than the rest of the first p-type region 506. The half-cell 500 also includes a primary trench 512, a gate electrode 514 disposed in the primary trench 512, and a dielectric arrangement 519 that fills the remaining space of the primary trench 512. The half-cell 500 also includes a secondary trench 520, a plug 522 disposed in the secondary trench 520, and a dielectric arrangement 524 (e.g., silicon dioxide) that fills the remaining space of the secondary trench 520. The half-cell 500 also includes a second p-type region 526, a first pickup arrangement 530, and a second pickup arrangement 534. For a more detailed description of these components or parts, please refer to the corresponding description (for the same components or parts) above in relation to Fig. 3A.

Fig. 6 shows a half-cell (right half) of a bidirectional SGT MOSFET in one embodiment of the invention. The half-cell 600 in Fig. 6 is generally the same as the half-cell (right half) of the cell 300 in Fig. 3A except without the lower shield electrode and with a shallower primary trench. In Fig. 6, components or parts that are the same as those in Fig. 3A are labeled using the same reference number used in Fig. 3A plus "300".

Briefly, the half-cell 600 includes a layer stack that provides a first n-type region 602, a second n-type region 604, a first p-type region 606, a third n-type region 608, and a fourth n-type region 610. The first p-type region 606 includes a portion 606C that has a higher level of doping hence higher electrical conductivity than the rest of the first p-type region 606. The half-cell 600 also includes a primary trench 612, a gate electrode 614 disposed in the primary trench 612, a shield electrode 616 disposed above the gate electrode 614, and a dielectric arrangement 619 that fills the remaining space of the primary trench 612. The half-cell 600 also includes a secondary trench 620, a plug 622 disposed in the secondary trench 620, and a dielectric arrangement 624 (e.g., silicon dioxide) that fills the remaining space of the secondary trench 620. The half-cell 600 also includes a second p-type region 626, a first pickup arrangement 630, and a second pickup arrangement 634. For a more detailed description of these components or parts, please refer to the corresponding description (for the same components or parts) above in relation to Fig. 3A.

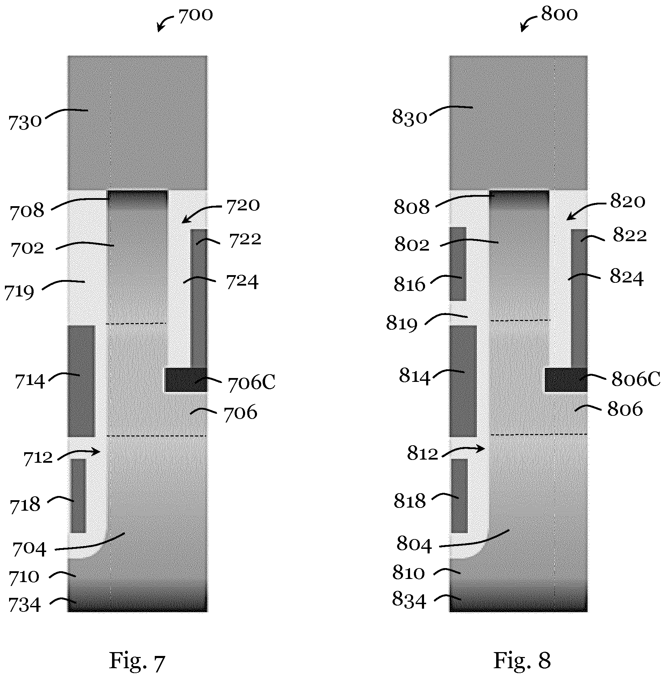

Fig. 7 shows a half-cell (right half) of a bidirectional SGT MOSFET in one embodiment of the invention. The half-cell 700 in Fig. 7 is generally the same as the half-cell (right half) of the cell 300 in Fig. 3A except without the upper shield electrode and the second p-type region. In Fig. 7, components or parts that are the same as those in Fig. 3A are labeled using the same reference number used in Fig. 3A plus "400".

Briefly, the half-cell 700 includes a layer stack that provides a first n-type region 702, a second n-type region 704, a first p-type region 706, a third n-type region 708, and a fourth n-type region 710. The first p-type region 706 includes a portion 706C that has a higher level of doping hence higher electrical conductivity than the rest of the first p-type region 706. The half-cell 700 also includes a primary trench 712, a gate electrode 714 disposed in the primary trench 712, a shield electrode 718 disposed below the gate electrode 714, and a dielectric arrangement 719 that fills the remaining space of the primary trench 712. The half-cell 700 also includes a secondary trench 720, a plug 722 disposed in the secondary trench 720, and a dielectric arrangement 724 (e.g., silicon dioxide) that fills the remaining space of the secondary trench 720. The half-cell 700 also includes a first pickup arrangement 730 and a second pickup arrangement 734. For a more detailed description of these components or parts, please refer to the corresponding description (for the same components or parts) above in relation to Fig. 3A.

Fig. 8 shows a half-cell (right half) of a bidirectional SGT MOSFET in one embodiment of the invention. The half-cell 800 in Fig. 8 is generally the same as the half-cell (right half) of the cell 300 in Fig. 3A except without the second p-type region. In Fig. 8, components or parts that are the same as those in Fig. 3A are labeled using the same reference number used in Fig. 3A plus "500".

Briefly, the half-cell 800 includes a layer stack that provides a first n-type region 802, a second n-type region 804, a first p-type region 806, a third n-type region 808, and a fourth n-type region 810. The first p-type region 806 includes a portion 806C that has a higher level of doping hence higher electrical conductivity than the rest of the first p-type region 806. The half-cell 800 also includes a primary trench 812, a gate electrode 814 disposed in the primary trench 812, a shield electrode 816 disposed above the gate electrode 814, a shield electrode 818 disposed below the gate electrode 814, and a dielectric arrangement 819 that fills the remaining space of the primary trench 812. The half-cell 800 also includes a secondary trench 820, a plug 822 disposed in the secondary trench 820, and a dielectric arrangement 824 (e.g., silicon dioxide) that fills the remaining space of the secondary trench 820. The half-cell 800 also includes a first pickup arrangement 830 and a second pickup arrangement 834. For a more detailed description of these components or parts, please refer to the corresponding description (for the same components or parts) above in relation to Fig. 3A.

It will be appreciated by a person skilled in the art that variations and/or modifications can be made to the described and/or illustrated embodiments of the invention to provide other embodiments of the invention, without departing from the scope of the invention as defined by the accompanying claims. In other words, the described and/or illustrated embodiments of the invention should be considered in all respects as illustrative, not restrictive.

In some embodiments, only a half-cell of a semiconductor device is described and/or illustrated. A skilled person appreciates that a cell can be formed by flipping a left half-cell to generate a right half-cell, or flipping a right half-cell to generate a left half-cell, and the combination of the left and right half-cells provide a single cell. In some embodiments, only a single cell of a semiconductor device is provided. A skilled person appreciates that the semiconductor device can have multiple ones of such cell arranged in parallel, one adjacent another. In other words, the cell can be treated as a repeating unit. For example, in some embodiments, the number of cells may not be four and the semiconductor device may not be a bidirectional shielded gate trench (SGT) MOSFET (as in the embodiment of Fig. 3B). In some examples, the cells or the semiconductor device is arranged in a single die or single chip. The level of electrical conductivity of each of the p- and n- type region can be controlled by the different levels of doping.

Some possible (non-exhaustive) variations and/or modifications are as follows. For example, the shape, size, arrangement, and/or spatial configuration of the components in the cell of the semiconductor device can be different from those specifically described and/or illustrated. For example, in some embodiments, the type of conductivity can be reversed (i.e., p-type replaced with n-type and vice versa). For example, the pickup arrangement may be replaced with an electrode. For example, the cell of the semiconductor device may include additional components not described and/or illustrated. For example, the cell of the semiconductor device may lack one or more of the components described and/or illustrated. For example, the method for providing a member in a cell of a semiconductor device can be modified from the method specifically described and/or illustrated, depending on the required construction of the cell or the semiconductor device. For example, the invention can also be applied to unidirectional semiconductor devices. For example, the invention can also be applied to one or more other types of semiconductor devices (e.g., planar gate semiconductor devices) that are not trench gate or shielded gate trench semiconductor devices.

## Claims

1. A semiconductor device comprising a cell (300; 500; 600; 700; 800), the cell comprising:
a first region (302; 502; 602; 702; 802) of a first conductivity type;
a second region (304; 504; 604; 704; 804) of the first conductivity type;
a third region (306; 506; 606; 706; 806) of a second conductivity type opposite to the first conductivity type, the third region being operably coupled between the first region and the second region;
a gate electrode (314; 514; 614; 714; 814) operably coupled with the third region to selectively allow or prevent current flow between the first region and the second region via the third region; and
a plug (322; 522; 622; 722; 822) electrically connected with the third region, the plug having a higher electrical conductivity than the third region and is operable to improve electrical conductivity of the third region;
wherein the first conductivity type is one of p-type or n-type, and the second conductivity type is another one of p-type or n-type.

2. The semiconductor device of claim 1, wherein the cell further comprises:
a first trench (312; 512; 612; 712; 812) extending in a first direction into the first region, the second region, and the third region; and
a dielectric arrangement arranged in the first trench;
wherein the gate electrode is arranged in the first trench and the dielectric arrangement surrounds the gate electrode in the first trench; and
wherein at least part of the third region is disposed between the first region and the second region in the first direction such that the first region and the second region are spaced apart in the first direction.

3. The semiconductor device of claim 2, wherein the cell further comprises:
a second trench (320; 520; 620; 720; 820) extending in the first direction into the first region and the third region;
wherein the second trench is spaced apart from the first trench in a second direction perpendicular to the first direction, and
wherein the plug is arranged in the second trench.

4. The semiconductor device of claim 3, wherein the cell further comprises:
a dielectric operably coupled between the plug and the first region;
wherein at least part of the dielectric is disposed in the second trench and between the plug and the first region.

5. The semiconductor device of claim 3 or 4, wherein the second trench and/or the plug extend in the first direction along an edge of the cell.

6. The semiconductor device of any one of claims 3 to 5, wherein the cell further comprises:
a fourth region (326; 526; 626) of the second conductivity type operably coupled with the third region;
wherein part of the second region is disposed between the first trench and the fourth region in the second direction.

7. The semiconductor device of claim 6, wherein the fourth region extends in the first direction and is in contact with the third region.

8. The semiconductor device of any one of claims 2 to 7, wherein the cell further comprises:
a shield electrode arranged in the first trench;
wherein the shield electrode is disposed on one side of the gate electrode in the first direction; and
wherein the dielectric arrangement further surrounds the shield electrode such the shield electrode and the gate electrode are not in contact with each other in the first trench.

9. The semiconductor device of any one of claims 2 to 7, wherein the cell further comprises:
first and second shield electrodes arranged in the first trench;
wherein one of the first shield electrode and the second shield electrode is disposed on one side of the gate electrode in the first direction;
wherein another one of the first shield electrode and the second shield electrode is disposed on another side of the gate electrode in the first direction; and
wherein the dielectric arrangement further surrounds the first shield electrode and the second shield electrode such the first shield electrode, the second shield electrode, and the gate electrode are not in contact with each other in the first trench.

10. The semiconductor device of any one of claims 1 to 9,
wherein the gate electrode is operable to selectively allow or prevent current flow from the first region to the second region via the third region and to selectively allow or prevent current flow from the second region to the first region via the third region.

11. The semiconductor device of any one of claims 1 to 10,
wherein the plug is metallic; or
wherein the plug is of the second conductivity type.

12. The semiconductor device of any one of claims 1 to 11,
wherein the third region comprises a first portion and a second portion having a higher level of conductivity than the first portion; and
wherein the plug is in contact with the second portion.

13. The semiconductor device of any one of claims 1 to 12, comprising multiple ones of the cell.

14. A method of providing a plug in a cell of a semiconductor device, the method comprising:
obtaining a semiconductor device comprising a cell, the cell comprising:
a first region of a first conductivity type;
a second region of the first conductivity type;
a third region of a second conductivity type opposite to the first conductivity type, the third region being operably coupled between the first region and the second region;
a gate electrode operably coupled with the third region to selectively allow or prevent current flow between the first region and the second region via the third region;
a first trench extending in a first direction into the first region, the second region, and the third region;
a dielectric arrangement arranged in the first trench; and
a second trench extending in the first direction into the first region and the third region, and spaced apart from the first trench in a second direction perpendicular to the first direction;
wherein the gate electrode is arranged in the first trench and the dielectric arrangement surrounds the gate electrode in the first trench; and
wherein at least part of the third region is disposed between the first region and the second region in the first direction such that the first region and the second region are spaced apart in the first direction;
forming a dielectric on a sidewall of the second trench, the sidewall being provided by the first region and part of the third region; and
forming a plug, which has a higher electrical conductivity than the third region, in the second trench with the dielectric such that (i) the plug is electrically connected with the third region, and (ii) at least part of the dielectric is disposed in the second trench and between the plug and the first region.

15. The method of claim 14,
wherein the plug is metallic, and forming the plug comprises depositing metal in the second trench;
or
wherein the plug is of the second conductivity type, and forming the plug comprises depositing material of the second conductivity type in the second trench.
